(19) Europäisches Patentamt
European Patent Office
Office européen des brevets

(11) EP 2 892 157 A1

(12) **EUROPEAN PATENT APPLICATION**

(43) Date of publication:
**08.07.2015 Bulletin 2015/28**

(21) Application number: **14305002.9**

(22) Date of filing: **02.01.2014**

(51) Int Cl.:
***H03M 13/11*** *(2006.01)* ***H03M 13/37*** *(2006.01)*
*H03M 13/15* *(2006.01)* *H03M 13/29* *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ALCATEL LUCENT**
**92100 Boulogne-Billancourt (FR)**

(72) Inventor: **Schmalen, Laurent**
**70435 Stuttgart (DE)**

(74) Representative: **2SPL Patentanwälte PartG mbB**
**Postfach 15 17 23**
**80050 München (DE)**

Remarks:
Amended claims in accordance with Rule 137(2) EPC.

(54) **Offset Min-Sum decoding of LDPC codes**

(57) Embodiments relate to a decoder (500) for iteratively decoding an LDPC encoded code word. The decoder comprises a decoding module (502) to decode the LDPC encoded code word according to an offset min-sum decoding rule applying at least one offset correction value ($\beta_1$; $\beta_2$) to a min-sum check-node update operation. The decoder (500) further includes a processor (506) to select, from a plurality of computation rules, a computation rule for the at least one offset correction value ($\beta_1$; $\beta_2$) dependent on a selection criterion.

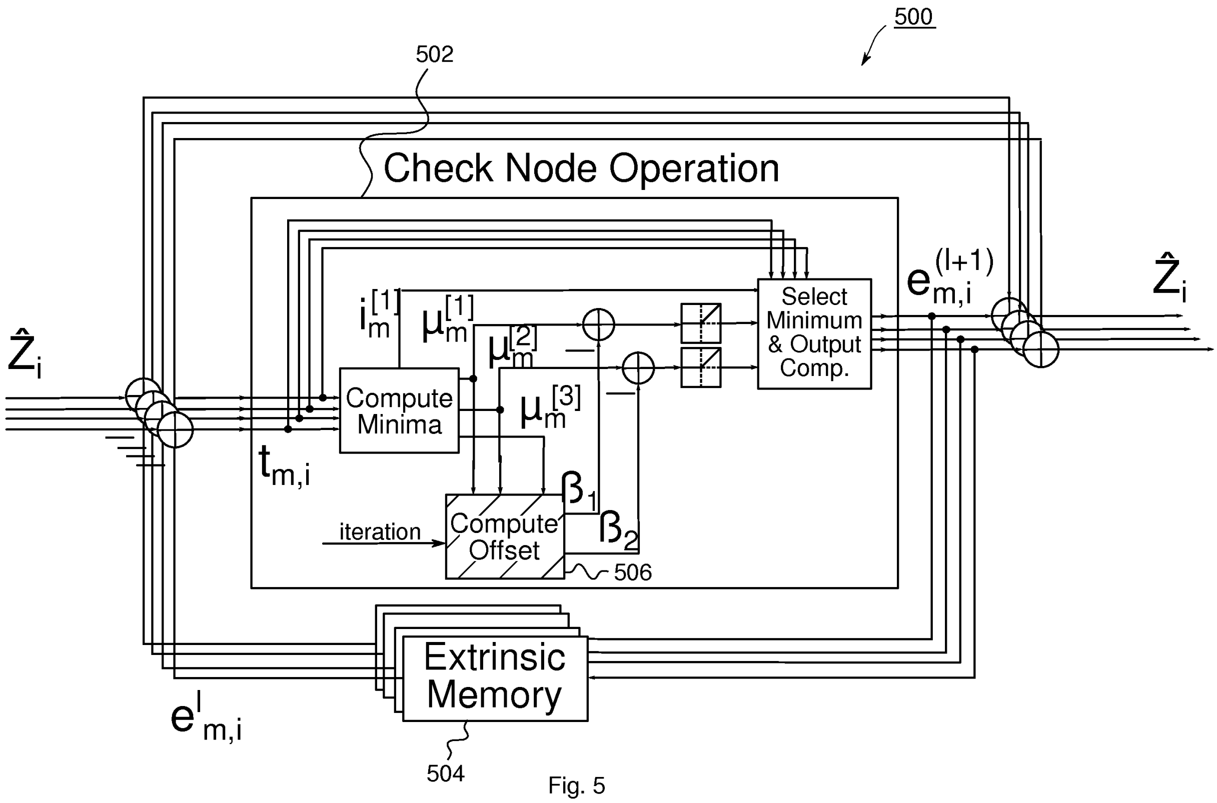


Fig. 5

EP 2 892 157 A1

Printed by Jouve, 75001 PARIS (FR)

## Description

Embodiments of the present invention relate to communication systems and, more particularly, to communication systems employing Low-Density Parity-Check (LDPC) codes.

### Background

This section introduces aspects that may be helpful in facilitating a better understanding of the inventions. Accordingly, the statements of this section are to be read in this light and are not to be understood as admissions about what is in the prior art or what is not in the prior art.

A Low-Density Parity-Check (LDPC) code is a linear error correcting code for transmitting a message over a noisy transmission channel, and may be constructed using a sparse bipartite graph whose vertices can be divided into two disjoint independent sets *U* and *V* such that every edge connects a vertex in *U* to one in *V*. An example of a bipartite graph used for LPDC codes is the so-called Tanner graph. In coding theory, Tanner graphs may also be used to construct longer codes from smaller ones. Both LPDC encoders and LPDC decoders may employ these graphs extensively.

An important application of LDPC codes is in optical or wireless communication systems. As the LDPC codes used in optical communications are mainly high-rate LDPC codes with rates higher than 0.8 (overhead smaller than 25%), these LDPC codes are usually based on parity check matrices of size $M$ (rows) $\times$ $N$ (columns), with $M << N$.

In optical communications, very low target Bit Error Rates (BERs) in the order of $10^{-15}$ should be achieved. However, practical LDPC codes suffer from inherent graph deficiencies that lead to so-called absorbing or trapping sets, causing an iterative decoder to get trapped. If the decoder gets trapped, some residual error patterns cannot be resolved and these errors pertain after decoding, causing the error floor, even if the input pre-FEC (FEC = Forward Error Correction) error rate is relatively low.

The error floor behavior of an LDPC code is strongly connected to the decoding algorithm that is employed. Usually, LDPC codes are decoded using the so-called Sum-Product Algorithm (SPA) or variants thereof, as very good performance can be achieved with limited complexity. The SPA is the basic "decoding" algorithm for codes on graphs. The full SPA update is however still too complex for use in systems operating at throughputs of 100Gbit/s and beyond. For this reason, easy-to-implement low-complexity approximations to the SPA have been derived in the art of channel coding. The most prominent and easiest algorithm is the so-called min-sum decoding algorithm. This algorithm suffers however from a relatively large Signal-to-Noise-Ratio (SNR) penalty, reducing the achievable coding gain.

Several remedies to close the performance gap between the SPA and min-sum algorithm have been proposed. Although these algorithms can increase the performance, they often lead to an increase in the error floor. Therefore, often an additional outer hard decision error correction code, for example, a Bose-Chaudhuri-Hocquenghem Code (BCH Code), Reed-Solomon or a concatenated BCH-BCH code) may be implemented to correct the residual bit errors such that the target error rate can be achieved.

However, it is desirable to avoid this outer decoder in order to simplify the decoder Verylarge-scale integration (VLSI) implementation complexity.

### Summary

Some simplifications may be made in the following summary, which is intended to highlight and introduce some aspects of the various exemplary embodiments, but such simplifications are not intended to limit the scope of the inventions. Detailed descriptions of a preferred exemplary embodiment adequate to allow those of ordinary skill in the art to make and use the inventive concepts will follow in later sections.

According to a first aspect, embodiments provide a decoder for iteratively decoding an LDPC encoded code word. The decoder comprises a decoding module which is configurable to decode the LDPC encoded code word according to an offset corrected min-sum decoding rule. The offset corrected min-sum decoding rule includes applying at least one offset value to a min-sum check-node update operation. Further, the decoder comprises a processor which is configured to select, from a plurality of computation rules, a computation rule for the at least one offset value dependent on a selection criterion.

According to a further aspect, embodiments provide a method for iteratively decoding an LDPC encoded code word. The method includes an act of decoding the LDPC encoded code word according to an offset corrected min-sum decoding rule applying at least one offset value to a min-sum check-node update operation, and an act of selecting, from a plurality of computation rules, a computation rule for the at least one offset value dependent on a selection criterion.

Some embodiments comprise digital circuitry installed within the decoder for performing the respective methods. Such a digital control circuitry, e.g., a Digital Signal Processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments

of the method, when the computer program is executed on a computer or a programmable hardware device.

Embodiments may help to improve bit error rate performance of communication systems, such as optical transport systems, for example. This may directly translate to improved coding gains and lower VLSI implementation complexity if an outer code can be avoided. The error floor of regular LDPC codes may be decreased with only small sacrifices in coding gain. This may have the implication that the outer code responsible for correcting the residual errors may possibly be avoided if the required target error rate is achieved by the proposed method, thereby decreasing the total overall VLSI implementation complexity of the decoder. A further implication may be that in a pipelined implementation, the decoding VLSI implementation complexity (e.g., chip area, number of gates/memory) may even be decreased as the final iterations require a simpler circuitry.

Brief description of the Figures

Some embodiments of apparatuses and/or methods will be described in the following by way of example only, and with reference to the accompanying figures, in which

Fig. 1 illustrates a transmission system with outer hard decision error correcting code to achieve low target bit error rates;

Fig. 2 shows a BER comparison of min-sum decoding and offset-min-sum decoding;

Fig. 3 illustrates a simplified description of a check-node decoding element in a layered LDPC decoder using the min-sum update rule;

Fig. 4 illustrates a check node operation for the offset-min-sum decoding algorithm;

Fig. 5 a block diagram of offset-min-sum Decoding with iteration-dependent offset-computation, according to an embodiment;

Fig. 6a illustrates an embodiment of unrolled, proposed offset-min-sum decoding with iteration-dependent offset-computation (min-sum decoding starts at iteration O);

Fig. 6b illustrates a further embodiment of unrolled, proposed offset-min-sum decoding with iteration-dependent offset-computation;

Fig. 7 illustrates an offset computation based on iteration counter and a-posteriori memory, according to an embodiment;

Fig. 8 shows simulation results for an embodiment of an iterative LDPC decoder with 6 offset-min-sum iterations followed by 4 min-sum iterations;

Fig. 9 illustrates an evaluation of a-posteriori fixed-point log-likelihood ratios at the variable nodes of a (7, 8) trapping set under offset-min-sum decoding; and

Fig. 10 illustrates an evaluation of a-posteriori fixed-point log-likelihood ratios at the variable nodes of a (7,8) trapping set under an embodiment of proposed scheme with the first 6 iterations utilizing the offset-min-sum decoding algorithm and the last 4 iterations utilizing a pure min-sum without correction decoder.

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element,

it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

**Fig. 1** illustrates a communication system overview, which will be used subsequently to further detail and explain some embodiments.

Fig. 1 shows a signal processing chain of a communication system 100, e.g., an optical communication system, which can also be provided by embodiments. The signal processing exemplarily starts at the upper left corner of Fig. 1 with an outer encoder 102, which may, for example, correspond to a BCH encoder, a Reed-Solomon encoder or a concatenated BCH-BCH encoder, for example. The task of the outer encoder 102 is to add redundancy to an input information word 101, which may comprise digitized data. A signal output 103 of the outer encoder 102 may then be input into an inner encoder 104, which may be an LDPC encoder 106, for example, to obtain (encoded) LPDC code words 105. The code words 105 are then modulated by the modulator 106 and transmitted through a transmission channel 108. Note that the blocks 102 to 106 make up a transmitter of the communication system 100. This can be an optical transmitter.

The modulation 106 may comprise a conversion from base band, which can be complex, to a transmission band as well as a conversion from a digital/electrical to an optical signal. In the present example an optical conversion and thus an optical transmission channel 106 is assumed.

At the receiver, a received signal 109 may be demodulated 110, where the demodulation 110 may include optical/electrical conversion and conversion from the transmission band to the complex base band. Demodulated code words 111 may be decoded by an inner decoder 112 corresponding to the inner encoder 104. The inner decoder 112 may be an (iterative) LDPC decoder, for example. A signal output 113 of the inner decoder 112 may then be input into an outer decoder 114 corresponding to the outer encoder 102. In embodiments the outer decoder 114 may be a BCH decoder, a Reed-Solomon decoder or a concatenated BCH-BCH decoder, for example.

In an optical communication system, like the one schematically illustrated in Fig. 1, low BERs in the order of $10^{-15}$ are targeted. However, practical LDPC codes which may be employed by blocks 104, 112 suffer from inherent graph deficiencies that lead to so-called absorbing or trapping sets, causing an iterative LDPC decoder 112 to get trapped. If the decoder 112 gets trapped, some residual error patterns cannot be resolved and these errors pertain after decoding, causing an error floor, even if the input pre-FEC error rate is relatively low. The error floor behavior of an LDPC code is strongly connected to the decoding algorithm that is employed. Usually, LDPC codes are decoded using the so-called Sum-Product Algorithm (SPA) or variants thereof, as very good performance can be achieved with limited complexity. As the full SPA update is still too complex for use in systems operating at throughputs of 100Gbit/s and beyond, easy-to-implement lowcomplexity approximations to the SPA have been derived in the art of channel coding. The most prominent and easiest algorithm is the so-called min-sum decoding algorithm. This algorithm suffers however from a relatively large Signal-to-Noise-Ratio (SNR) penalty, reducing the achievable coding gain.

Several remedies to close the performance gap between the SPA and min-sum algorithm have been proposed. Although these algorithms can increase the performance, they often lead to an increase in the error floor. Therefore, the additional outer hard decision error correction code 102, 114 may be implemented to correct the residual bit errors such that the target error rate can be achieved.

Such a situation is shown in **Fig. 2** illustrating a BER comparison between an iterative min-sum decoding algorithm (see reference numeral 202) and an iterative offset corrected min-sum decoding algorithm (see reference numeral 204). Although the offset corrected min-sum decoding algorithm achieves a performance gain of approximately 0.35 dB over the min-sum decoding algorithm, the offset corrected min-sum decoding algorithm suffers from an error floor at BERs below $10^{-10}$. Embodiments aim to get rid of such error floors and, hence, of the outer decoder 114 in order to simplify the decoder VLSI implementation complexity at a receiver. Note that the BER of zero obtained with the iterative min-sum decoding at Eb/N0 = 3.9 dB (reference numeral 202) does not indicate the complete absence of an error floor but only that no error have been observed within the (limited number of) decoding steps performed in the simulation.

For a better understanding of embodiments a short introduction to LDPC codes and some related decoding algorithms will be provided in the following.

An LDPC code may be defined by a sparse binary parity check matrix **H** of dimension $M \times N$, where $N$ is the LDPC code word length (in bits) of the LDPC code and $M$ denotes the number of parity bits. The rows of a parity check matrix are parity checks on the code words of a code. That is, they show how linear combinations of certain digits of each code word equal zero. Usually, the number of information bits equals $M$-$N$. The design rate of the code amounts to $r = (N\text{-}M)/N$. The overhead of the code is defined as OH = $1/r - 1 = M/(N\text{-}M)$. Sparse means that the number of 1s in **H** is small compared to the number of zero entries. Practical LDPC codes usually have a fraction of "1s" that is below 1% by several orders of magnitude.

We start by introducing some notation and terminology related to LDPC codes. Each column of the parity check matrix **H** corresponds to one bit of a Forward Error Correction (FEC) frame or LPDC code word. As LDPC codes can also be represented in a graphical structure called Tanner graph (which we will not introduce here), the columns of **H** and thus the FEC frame (LPDC code word) bits are sometimes also called variable nodes, referring to the graph-theoretic representation. Similarly, each row of **H** corresponds to a parity check equation and ideally defines a parity bit, if **H** has full rank. For example, the rank can be defined as the column rank. The column rank of a matrix **H** is the maximum number of linearly independent column vectors of **H.** Correspondingly, the row rank of **H** is the maximum number of linearly independent row vectors of **H.** Owing to the Tanner graph representation, the rows of **H** are associated to so-called check nodes, and the columns of **H** are associated to so-called variable nodes. Further, the $M$ rows of **H** specify $M$ check node connections, and the $N$ columns of **H** specify $N$ variable node connections. Thereby, check node $i$ is connected to variable node $j$ whenever element $h_{i,j}$ in **H** is a 1. Note that the row rank and the column rank of a matrix **H** are always equal, which is a well-known result in linear algebra.

In order to describe an exemplary LDPC decoder 112 we introduce some additional notation. First, we denote by **x** the vector of $K = N - M$ information bits. The single elements of x are denoted by $x_i$, i.e., $\mathbf{x} = (x_1, x_2, ..., x_i, ..., x_K)^T$. After encoding with an exemplary LDPC encoder 104, the LDPC code word 105 $\mathbf{y} = (y_1, y_2, ..., y_N)^T$ of length $N$ results. We denote by $y_i$ the single bits of the code word y. The LDPC code is said to be systematic if the information vector **x** is included in the code word, e.g., if y = $(x_1,..., x_K, p_1, ... p_M)^T$, with $\mathbf{p} = (p_1, ..., p_M)^T$ denoting the vector of M parity bits. Furthermore, let the set $N(m)$ denote the positions of the 1s in the $m$-th row of **H**, i.e., $N(m) = \{i: H_{m,i} = 1\}$. A binary vector y is a code word of the LDPC code defined by **H,** if **Hy** = **0,** with the additions defined over the binary field (addition modulo-2, or XOR, respectively). The set of code words is thus defined to be the null space of **H.** This signifies that the product of each row of **H** and y is zero, or $\sum_{j \in \mathcal{N}(m)} y_j = 0,$ for all $m$ with $1 \le m \le M$.

Let us illustrate the concept of LDPC codes by a "toy" example. This example defines a parity check matrix **H** of two concatenated (4, 5) single parity check codes, separated by a 4x5 block-interleaver. The exemplary parity check matrix **H** of dimension 9x25 is given by

$$\mathbf{H} = \begin{pmatrix} 1&1&1&1&&&&&&&&&&&&&1&&&&&&&& \\ &&&&1&1&1&1&&&&&&&&&&1&&&&&&& \\ &&&&&&&&1&1&1&1&&&&&&&1&&&&&& \\ &&&&&&&&&&&&1&1&1&1&&&&1&&&&& \\ 1&&&&1&&&&1&&&&1&&&&&&&&1&&&& \\ &1&&&&1&&&&1&&&&1&&&&&&&&1&&& \\ &&1&&&&1&&&&1&&&&1&&&&&&&&1&& \\ &&&1&&&&1&&&&1&&&&1&&&&&&&&1& \\ &&&&&&&&&&&&&&&&1&1&1&1&&&&&1 \end{pmatrix}.$$

Note that for simplicity reasons only the 1s are illustrated in the parity check matrix **H** above. Thus, $M$= 9, $N$ = 25, and the code has an overhead of 56% (given by $M/(N - M)$) or a rate of $r$ = 0.64, equivalently. We have $N(1) = \{1; 2; 3; 4; 17\}$, $N(2) = \{5; 6; 7; 8; 18\}$, $N(3) = \{9; 10; 11; 12; 19\}$, $N(4) = \{13; 14; 15; 16; 20\}$, $N(5) = \{1; 5; 9; 13; 21\}$, $N(6) = \{2; 6; 10; 14; 22\}$, $N(7) = \{3; 7; 11; 15; 23\}$, $N(8) = \{4; 8; 12; 16; 24\}$, $N(9) = \{17; 18; 19; 20; 25\}$. This means for instance that we have (using the first row of **H**) $y_1+y_2+y_3+y_4+y_{17}=0$, or, if the code is systematic, $x_1+x_2+x_3+x_4+p_1=0$, i.e., $p_1=x_1+x_2+x_3+x_4$, defines the first parity bit.

One of the most common decoding algorithms for LDPC codes is the so-called "sum-product" decoding algorithm and its simplified versions. These algorithms can be described either in a graph structure commonly denoted Tanner graph, or given directly in a form suitable for implementation. While the former is advantageous for describing and understanding the underlying operations, we only focus on the latter in this specification.

In the context of coherent detection, we can usually assume an equivalent Additive White Gaussian Noise (AWGN) channel model for the transmission channel 108. This assumption is justified by the central limit theorem which applies due to the extensive use of filtering in inner Digital Signal Processing (DSP) stages of the transmitter and/or receiver. If we denote *by* $y_i$ ($i$ = 1, ..., $N$) the single bits of an LDPC code word y as defined above, then the received values at the input of the LDPC decoder 112 amount to $z_i = y_i + n_i$, with $n_i$ (i = 1, ..., N) being Gaussian distributed noise samples of zero mean and variance $\sigma^2$. Usually, the received noisy samples are converted into the Log-Likelihood Ratio (LLR) domain, which leads to a numerically more stable decoder implementation. The LLR of a received sample $z_i$ may be defined as

$$L(z_i) = \log\left(\frac{p(z_i \mid y_i = 0)}{p(z_i \mid y_i = 1)}\right) \tag{1}$$

with $p(z_i \mid y_i = k) = \exp\left(-(z_i - (1-2k))^2/(2\sigma^2)\right)/\sqrt{2\pi\sigma^2}$ denoting the probability density function (pdf) of the received sample $z_i$ under AWGN assumption conditioned on the transmitted bit $y_i$ and with bipolar signaling ($y_i$=0 → +1, $y_i$=1→ -1). Conveniently, it turns out that $L(z_i) = z_i \cdot 2/\sigma^2 = z_i \cdot L_c$ under the AWGN assumption. Usually, the value $L_c = 2/\sigma^2$ is assumed to be constant and predetermined.

Turning now to Fig. 3, we describe a conventional row-layered LDPC decoding algorithm, as introduced in D. E. Hocevar, "A Reduced Complexity Decoder Architecture via Layered Decoding of LDPC Codes," in Proc. IEEE Workshop on Signal Processing Systems (SIPS), 2004. Here, the LDPC decoder continuously updates the received LLR values with the goal to compute LLRs that approximate the Maximum A Posteriori (MAP) values. The received vector of LLRs **z** 111 is therefore copied to a memory $\hat{\mathbf{z}}$ of size $N$, which is continuously updated. The decoding operation in the row-layered decoder 112 comprises three acts, where a) the first act prepares the input data, b) the second act performs the computation of new extrinsic data and c) the final act updates the LLR memory. The row-layered LDPC decoder 112 carries out the three steps sequentially for each row of the parity check matrix **H.** After all rows have been considered, a single decoding iteration has been carried out. The LDPC decoder 112 usually carries out several iterations, where the number depends on the available resources.

In the following, we describe the aforementioned three acts for a single row $m$ of **H.** The first step a) comprises computing $card(N(m)) = d_c$ (card = cardinality) temporary values $t_{m,i}$, with

$$t_{m,i} = \hat{z}_i - e_{m,i}^{(l)} \qquad \text{for all } i \in \mathcal{N}(m) \tag{2}$$

for all non-zero entries (indexed by $i$) of the $m$'th row of **H.** The superscript$^{(l)}$ denotes the iteration counter, i.e., the operations are carried out in the $l$-th iteration of the row-layered LDPC decoding procedure. The value $e_{m,i}$ is the (stored) extrinsic memory for row $m$ and variable $\hat{z}_i$. At the beginning of the decoding of a single LDPC frame (code word), all $e_{m,i}$ may be initialized by zero (i.e., $e_{m,i}^{(1)} = 0$) and then continuously updated. Note that in total only $\Sigma_m$ card($N$($m$)) memory locations may be used for storing the $e_{m,i}$. If the code is check-regular, $\Sigma_m$ card($N$($m$)) = $M \cdot d_c$. In the second step, the extrinsic memory for the subsequent iteration ($l$+1) is updated using the $t_{m,i}$ according to

$$e_{m,i}^{(l+1)} = 2 \cdot \tanh^{-1}\left( \prod_{j \in \mathcal{N}(m)\setminus\{i\}} \tanh\left(\frac{t_{m,j}}{2}\right)\right) \qquad \text{for all } i \in \mathcal{N}(m)$$

$$= \left[\prod_{j \in \mathcal{N}(m)\setminus\{i\}} \operatorname{sign}\left(t_{m,j}\right)\right] \cdot \phi\left( \sum_{j \in \mathcal{N}(m)\setminus\{i\}} \phi\left(\left|t_{m,j}\right|\right)\right), \quad \text{with } \phi(\tau) = -\log\left(\tanh\left(\frac{\tau}{2}\right)\right) = \log\left(\frac{e^{\tau}+1}{e^{\tau}-1}\right) \tag{3}$$

where the log-domain expression of the Sum-Product Algorithm (SPA) according to equation (3) may be more suitable for practical implementations, as the multiplication is replaced by an addition and instead of two functions $\tanh(\cdot)/\tanh^{-1}(\cdot)$, only a single function $\phi(\cdot)$ needs to be implemented (or approximated by a look-up table). The product (or the sum) of equation (3) may be carried out over all entries in $N(m)$ except the one under consideration $i$. This is indicated by the notation $N(m)\setminus\{i\}$. For instance, in the above example, where $N(5)=\{1; 5; 9; 13; 21\}$, $e_{5,13}^{(l+1)}$ may be computed corresponding to

$$e_{5,13}^{(l+1)} = 2 \cdot \tanh^{-1}\left( \prod_{j \in \mathcal{N}(5)\setminus\{13\}} \tanh\left(\frac{t_{m,j}}{2}\right)\right) = 2 \cdot \tanh^{-1}\left( \prod_{j \in \{1;5;9;21\}} \tanh\left(\frac{t_{m,j}}{2}\right)\right)$$
$$= 2 \cdot \tanh^{-1}\left( \tanh\left(\frac{t_{5,1}}{2}\right)\tanh\left(\frac{t_{5,5}}{2}\right)\tanh\left(\frac{t_{5,9}}{2}\right)\tanh\left(\frac{t_{5,21}}{2}\right)\right). \tag{4}$$

The derivation of equation (4) for the extrinsic update is beyond the scope of this specification. Usually, if high LDPC decoder throughputs shall be achieved, the computation of $e_{m,i}$ can be further simplified. An often employed simplification of the SPA log-domain equation (3), which we will consider in the following, is the so-called min-sum approximation or min-sum algorithm which leads to

$$e_{m,i}^{(l+1)} = \left[\prod_{j \in \mathcal{N}(m)\setminus\{i\}} \operatorname{sign}(t_{k,j})\right] \min_{j \in \mathcal{N}(m)\setminus\{i\}} |t_{m,j}| \qquad \text{for all } i \in \mathcal{N}(m). \tag{5}$$

As the second act b) computes the output of the parity check node m of the check node in the graphical representation of LDPC codes, it is frequently denoted by check node operation. Hence, equation (5) may be denotes as min-sum check-node update operation having reduced complexity vis-à-vis the SPA check-node update operations of equation (3).

Finally, in the next decoding act c), the LLR memory may be updated corresponding to

$$\hat{z}_i = t_{m,i} + e_{m,i}^{(l+1)} \qquad \text{for all } i \in \mathcal{N}(m) \tag{6}$$

and the LDPC decoder 112 may continue with decoding row $m$+1 or, if $m = M$, restarts at $m$ = 1 (next iteration, $l$ + 1).

**Fig. 3** shows the simplified block diagram 300 of the min-sum check-node update operation for computing $e_{m,i}^{(l+1)}$ according to equation (5) for card ($N(m)$) = 4 (i.e., **H** contains for 1s at row $m$).

As has been explained before, the check node operation 302 may be realized by equations (3) (log-domain SPA) or (5) (min-sum domain). Note that a routing network to access the different $\hat{z}_i$, (which are not necessarily stored in neighboring memory locations) is not shown in the Fig. 3.

The second step b), i.e., the check-node update, can be further simplified in actual implementations. Let

$\mu_m^{[1]} = \min_{j \in \mathcal{N}(m)} |t_{m,j}|$ be the first minimum of the absolute value of all involved incoming messages $t_{m,j}$ at row m and let $i_m^{[1]} = \arg\min_{j \in \mathcal{N}(m)} |t_{m,j}|$ be the position (i.e., the index) of this first minimum. Let furthermore $\mu_m^{[2]} = \min_{j \in \mathcal{N}(m) \setminus \{i_m^{[1]}\}} |t_{m,j}|$ be the second minimum (larger than the first minimum) of all incoming messages at row *m*. We further define $s_m = \prod_{j \in \mathcal{N}(m)} \mathrm{sign}(t_{m,j})$. The output message can then be computed corresponding to

$$e_{m,i}^{(l+1)} = s_m \cdot \mathrm{sign}(t_{m,i}) \cdot \begin{cases} \mu_m^{[1]} & \text{if } i \neq i_m^{[1]} \\ \mu_m^{[2]} & \text{if } i = i_m^{[1]} \end{cases} . \tag{7}$$

Note that equation (7) is an alternative representation of the min-sum check-node update operation of equation (5). Thus, one burden for implementing the check node operation 302 for computing $e_{m,i}^{(l+1)}$ consists in finding the first and second minimum of the incoming messages together with the position of the first minimum. The memory requirements of this algorithm are *N* memory cells for storing the (continuously updated) a-posteriori values $\hat{z}_i$. Additionally, the storing requirements of the extrinsic memory $e_{m,i}$ 304 amount to the total number of 1s in the parity check matrix **H,** however, due to the simplified implementation using the minimum approximation, the extrinsic memory 304 does not need to store all $d_c$ different values per row, but only the $d_c$ different signs, both minima $\mu_m^{[1]}$ and $\mu_m^{[2]}$, and the location index of the first minimum $i_m^{[1]}$. The values $e_{m,i}$ can then be computed on the fly as required.

As the min-sum algorithm according to equations (5) or (7) is only an approximation to the full belief-propagation expression of equation (3), numerous attempts have been made to improve the performance of the min-sum algorithm, i.e., the min-sum check-node update operation. One notable improvement is the so-called offset min-sum algorithm, see J. Zhao, F. Zarkeshvari, A. H. Banihashemi, "On Implementation of Min-Sum Algorithm and Its Modifications for Decoding Low-Density Parity-Check (LDPC) Codes," IEEE Trans. Commun., vol. 53, no. 4, Apr. 2005. The check-node update rule of the offset min-sum algorithm reads

$$e_{m,i}^{(l+1)} = s_m \cdot \mathrm{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases} , \tag{8}$$

where the offset correction variable β can either be constant and determined offline or be updated during decoding according to a predefined rule.

A more general offset-min-sum check-node update operation is given by

$$e_{m,i}^{(l+1)} = s_m \cdot \mathrm{sign}(t_{m,i}) \cdot \begin{cases} \max(\mu_m^{[1]} - \beta_1(\mu_m^{[1]}, \mu_m^{[2]}, \mu_m^{[3]}), 0) & \text{if } i \neq i_m^{[1]} \\ \max(\mu_m^{[2]} - \beta_2(\mu_m^{[1]}, \mu_m^{[2]}, \mu_m^{[3]}), 0) & \text{if } i = i_m^{[1]} \end{cases} \tag{9}$$

with $\mu_m^{[3]} = \min_{j \in \mathcal{N}(m) \setminus \{i_m^{[1]}, i_m^{[2]}\}} |t_{m,j}|$ being the third minimum of the incoming message values and $\beta_1$ as well as $\beta_2$ being functions returning offset correction values depending on the first three minima. **Fig. 4** shows a detailed block diagram

of an offset-min-sum layered decoder 400 and its offset-min-sum check-node update module 402, carrying out the computation described by equation (9).

A simulation example for a regular rate R = 0.826 (21 % overhead) code (variable degree dv=4) has already been shown in Fig. 2. The iterative LDPC decoder 112 executes 10 layered decoding iterations using either min-sum decoding (reference numeral 202) according to equation (5) or (7), or offset-corrected min-sum decoding (reference numeral 204) according to equation (8) or (9). We can clearly see that the offset min-sum algorithm according to equation (8) or (9) allows realizing additional coding gains of around 0.5 dB. But we can also observe the error floor appearing for the offset min-sum decoding rule according to equation (8) or (9).

As already mentioned, a large number of error floor reduction techniques have been presented. These include a post-processing routine altering the outgoing messages of unfulfilled check nodes or adapting a quantizer resolution within the decoding loop. These methods can be summarized under the term "bi-mode decoder", see W. E. Ryan and S. Lin, Channel Codes - Classical and Modem, Cambridge University Press, 2009. In this text book many different varieties of this scheme are discussed: generating erasure sets such that in a second post-processing stage only erasures are processed. Another scheme flags different variables according to check node computation and flips the sign of the flagged bits according to a predefined algorithm. Other solutions include bit-pinning, where a code is designed such that the bits of some known, harmful absorbing sets are shortened and then set to perfectly known values at the receiver. This solution however requires a complete re-design of the LDPC coding scheme and cannot be adapted to an existing pre-defined coding scheme. Another solution is to group some check nodes belonging to a trapping set to a larger code and apply the framework of generalized LDPC decoding to this super-check node using e.g., a trellis-based Bahl-Cocke-Jelinek-Raviv (BCJR) decoder. This solution however suffers from a high VLSI implementation complexity, such that it is currently unattractive for implementations operating at decoding speeds to more than 100 Gbit/s.

An idea underlying embodiments of the present invention is to combine advantages of the offset-min-sum and pure min-sum decoding algorithms to implement a combined decoding scheme with good error floor properties and high coding gains while keeping the VLSI implementation complexity low.

Embodiments are based on an offset-min-sum decoding algorithm with an offset-computation engine which determines one or more offset correction values dependent on some selection criterion, for example, dependent on a decoding iteration counter. Embodiments provide an LDPC decoder for iteratively decoding one or more LDPC encoded code words. The LDPC decoder comprises a decoding module which is configured to decode an LDPC encoded code word (or LDPC frame) according to an offset min-sum decoding rule applying at least one offset value $\beta$ to a min-sum check-node update operation. The offset min-sum decoding rule may be according to equation (8) or (9), for example. Further the LDPC decoder further comprises a processor to select, from a plurality of computation rules, a computation rule for the at least one offset value $\beta$ dependent on a selection criterion.

Embodiments of the LDPC decoder may be implemented in a receiver of an optical communication system, for example. It may perform, e.g., by means of adequately programed digital signal processors, a corresponding decoding method including an act of decoding the LDPC encoded code word according to an offset min-sum decoding rule applying at least one offset correction value to a min-sum check-node update operation, and an act of selecting, from a plurality of computation rules, a computation rule for the at least one offset correction value ($\beta_1$; $\beta_2$) dependent on a selection criterion.

An implementation of an example LDPC decoder 500 employing a selection-criterion-dependent offset min-sum decoding rule is illustrated in **Fig. 5,** where a modified offset computation engine 506 is highlighted. Compared to Fig. 4 the modified offset computation engine or processor 506 may have an iteration counter 508 as an additional input. We may denote the resulting LDPC decoder 500 by "hybrid offset-min-sum decoder" as it allows switching either between different offset computations rules/factors or between offset-min-sum and pure min-sum decoding.

Let us consider some different embodiments:

In some embodiments of the hybrid offset-min-sum decoder 500 the offset correction, e.g., according to equation (8) or (9) may be switched off after a certain number of iterations. In such embodiments the processor 506 may be configured to set the at least one offset value $\beta$ to zero ($\beta = 0$) if a zero selection criterion is fulfilled, such that the decoding module 500 decodes the LDPC encoded code words according to the pure min-sum check-node update operation according to equation (5) or (7).

For example, the selection criterion may correspond to a number $O$ of decoding iterations. In some embodiments the zero selection criterion may be fulfilled if a number of decoding iterations exceeds an iteration threshold value $O$. Thereby the number $O$ of decoding iterations may be variable or predefined.

We denote by $O$ the iteration at which offset-min-sum decoding according to equations (8) or (9) is switched off and pure min-sum decoding according to equation (5) or (7) is used. Starting from iteration $O$ (i.e., at iterations $O$, $O+1$, $O+2$, ....), the offset correction factors $\beta_1$, $\beta_2$ may be set to zero, i.e., $\beta_1 = \beta_2 = 0$. This decoder behavior may allow recovering from certain harmful situations causing an error floor, as will be shown further below.

In high-speed, high-throughput optical communications, some embodiments propose an unrolled iterative LDPC decoder, such that a decoding pipeline is implemented. That is to say, for each decoding iteration $l$, an individual hardware

decoding stage 500-*l* may be implemented. Hence, there may be ten hardware decoding stages for implementing ten decoding iterations, instead of one decoding stage in a feedback loop. The LDPC decoder may hence comprise a plurality of pipelined decoding modules or stages 500-*l*. A total number of the pipelined decoding modules may correspond to a total number of decoding iterations. A first number of the pipelined decoding modules may correspond to a first number of decoding iterations. The first number of decoding modules may operate in accordance with an offset min-sum decoding rule applying at least one non-zero offset correction value to a min-sum check-node update operation. A second number of the pipelined decoding modules may correspond to a second number of decoding iterations. The second number of decoding modules may operate in accordance with a pure min-sum check-node update operation. This situation is depicted in **Fig. 6a,** which exemplarily shows three stages 500-(*O*-2), 500-(*O*-1), and 500-*O* of a decoding pipeline 600. While in decoding stages 500-1 to 500-(*O*-1) the exemplary offset corrections factors $\beta_1$, $\beta_2$ may be different from zero, i.e., $\beta_1 \neq 0$, $\beta_2 \neq 0$, the offset corrections factors $\beta_1$, $\beta_2$ may be set to zero ($\beta_1 = \beta_2 = 0$) starting from decoding stage 500-*O*. If the iteration threshold parameter *O* is fixed (as it may have been predetermined in offline simulations to yield the best compromise between decoding performance and error floor behavior), the decoder VLSI implementation can be hugely simplified as the offset correction only needs to be implemented for the first *O*-1 iterations. **Fig. 6b** illustrates an exemplary unrolled decoding pipeline comprising five offset min-sum decoding st(e.g. $\beta_1 \neq 0$, $\beta_2 \neq 0$) ages followed by three uncorrected (pure) min-sum decoding stages ($\beta_1$ = β2 = 0). That is, pure min-sum decoding starts at iteration 6 in this example.

Additionally, in some embodiments a second selection criterion besides the iteration for switching off the offset-correction may be used. For example, we may define an iteration window $[O_{min}, O_{max}]$. If the iteration counter *l* is within this iteration window, the offset correction according to equation (8) or (9) may be switched off, if some other criterion is fulfilled. That is to say, in some embodiments the processor 506 may be operable select a computation rule for the at least one offset value $\beta_1$, $\beta_2$ dependent on a plurality of selection criteria, which may be fulfilled at the same time. A second selection criterion may for instance be the (variation of) the number of unfulfilled check nodes, or the minimum a-posteriori value(s) connected to the unfulfilled check nodes. Hence, the selection criterion may correspond to a number of decoding iterations, to a number of unfulfilled check node operations, or reliability values of a number of variable nodes participating in unfulfilled check node operations, such as the minimum a-posteriori value(s) connected to the unfulfilled check nodes, or a combination thereof. This is illustrated in **Fig. 7.** Note that in Fig. 7, the offset computation of block 506 is only connect to those a-posteriori values $\hat{z}_i$ entering a specific check node. However, this may be generalized to the case where all a-posteriori values of a complete LDPC frame may be used to steer the offset computation 506.

In some embodiments the offset correction according to equations (8) or (9) may be switched off based on some selection criterion which is independent of the number of iterations. One such selection criterion could for instance be the number of unfulfilled check equations, i.e., check equations (corresponding to rows of the parity check matrix **H**) which are evaluated using a temporary hard decision based on the values $\hat{z}_i$ and which have as a result a value different from zero. The multiplication of a the hard decision vector of the values $\hat{z}_i$ of size *N* multiplied with the parity check matrix **H** results in a (binary) vector of size *M*. Each "1" in this vector indicates an unfulfilled parity check equation (as there are *M* parity check equations defining the code). If the number of unfulfilled check equations (i.e., the weight of the aforementioned vector of size *M* resulting from the multiplication of the parity check matrix with the temporary hard decision vector) is small and does not vary from iteration to iteration, there is a strong indication that the decoder is trapped in a trapping set causing the error floor. Switching off the offset correction, e.g., according to equation (8) or (9) could help in this case to recover from the error pattern. Hence, the zero selection criterion (for $\beta_1 = \beta_2 = 0$) may be fulfilled if a number of unfulfilled check node operations is below a check node threshold value and/or the number of unfulfilled check node operations does not substantially vary between subsequent iterations. For example, the number of unfulfilled check equations should not vary by more than 5-10% between subsequent iterations and should be lower than a certain threshold (e.g., 20 unfulfilled check equations).

Alternatively or additionally, the offset correction may either be switched off completely for all check nodes of a given LDPC code within a decoding iteration or only partly. For example, the offset correction according to equations (8) or (9) may stay enabled for only a part of the considered check nodes (rows of **H**) and may stay disabled for another part. Thereby the partitioning may either be predetermined offline or may be determined on the fly using a certain selection criterion. Such a selection criterion may for instance be the number of unfulfilled check equations, the absolute values of the connected variables taking part in unfulfilled check equations (i.e., the absolute values, indicating the reliability of the bit at posisition *i*) of those variables $\hat{z}_i$ which, after temporary hard decision take part in the *j*'th check equation, meaning that $h_{j,i} \neq 0$), or the variation of certain parameters, the (estimated) mutual information, and more.

Instead of completely switching off the offset correction (i.e., setting $\beta_1 = \beta_2 = 0$), the computation of the offset variables $\beta_1$ and/or $\beta_2$ may also be modified if some predetermined selection criterion is fulfilled, such as the ones described before. For example, the processor may be operable to select, from a plurality of constant values, a constant value for the at least one offset value $\beta_1$, $\beta_2$, the constant value depending on the selection criterion. Also, the processor may be operable to select, from a plurality of mathematical functions, a mathematical function for computing the at least

one offset value $\beta_1$, $\beta_2$, the mathematical function depending on the selection criterion.

Additionally or alternatively some embodiments may use some intermediate steps, for example to slowly fade between offset min-sum according to equations (8) or (9) and pure min-sum decoding according to equations (5) or (7): Let for instance be $\beta_{orig,1} = \beta_{orig,2}$ denote original correction factors determined by the initially employed offset min-sum decoder according to equations (8) or (9). In iterations 1, 2, ..., $O$-1, we may set $\beta_1 = \beta_{orig,1}$ and $\beta_2 = \beta_{orig,2}$. In iterations $O$, $O$+1,...,$P$-1, we may set $\beta_1 = \beta_{orig,1}/2$ and $\beta_2 = \beta_{orig,2}/2$, for example. Finally, in iterations P, $P$+1, $P$+2,.... we may set $\beta_1 = \beta_2 = 0$. Finer granularities are also possible of course. Furthermore, different modifications of the computation are also possible. Hence, in such embodiments the processor 506 may be operable to select a first computation rule for the at least one offset value $\beta_1$, $\beta_2$ if a first selection criterion is fulfilled (e.g., $O \le I < P$) and/or to select a second computation rule for the at least one offset value $\beta_1$, $\beta_2$ if a second selection criterion is fulfilled (e.g., $I \ge P$).

In some embodiments we may also combine any the above proposed concepts with a modification of the decoder fixed point resolution. This means that a quantization resolution of the iterative LDPC decoder may for example be changed either simultaneously with the offset correction method (at iteration $O$), or at a different instant before or after $O$, i.e., at $O$+$J$, with $J \in \{\pm 1, \pm 2, \pm 3, \pm 4,...\}$. Other variations of this scheme are also possible. The processor 506 may hence be operable to select a quantization resolution of the iterative LDPC decoder in accordance with the selection criterion or a selected computation rule for the at least one offset correction value.

Referring now to **Fig. 8,** we present some benefits of the proposed scheme for the simulation example previously described with reference to Fig. 2. We use the same code of rate $R$=0.826 (21% overhead, variable degree $d_v$=4). The decoder executes 10 layered decoding iterations using either min-sum decoding (202) or offset-corrected min-sum decoding (204). We now also use an embodiment of the modified hybrid solution (802) with 10 total iterations whereof the first 6 iterations are carried out using the offset-min-sum algorithm (responsible for good SNR performance) and the last 4 iterations are carried out using the pure min-sum algorithm (responsible for (partly) cleaning up the error floor). The results are shown in Fig. 8 for transmission over an AWGN channel. We can clearly see that the proposed hybrid algorithm (reference numeral 802) has a better error floor performance than the offset-min sum decoder (reference numeral 204), at the expense of slightly increasing the error rate in the waterfall region (i.e., at low SNRs). At 3.58 dB $E_b/N_0$, the BER can be decreased by a factor 10.

In order to show the decoding behavior of the proposed scheme, we take a look at a harmful structure causing the error floor. We consider a frame at a channel quality of $E_s/N_0$ = 3.52 dB. After carrying out 10 iterations of offset-min-sum decoding, 7 residual errors persist after. These errors belong to a so-called trapping set, which is a harmful structure in the graph of the code. The trapping set consists of 7 code bits. If those bits are erroneous, they are connected to 8 unfulfilled and 10 fulfilled check nodes. As the number of fulfilled check nodes is larger than the number of unfulfilled check nodes, the decoder may not be able to recover from the error. We assume that the all-zero codeword has been transmitted, which corresponds to positive log-likelihood ratios. **Fig. 9** shows the received values of the 7 initial bits in the trapping set (initial configuration). All 7 values are negative, i.e., they will be decided to a binary "1". Fig. 9 also shows the evaluation of the a-posteriori values at the trapping set during layered fixed-point decoding (resolution 7 bit). We use underlined and double-underlined values to highlight values that change from iteration to iteration with underlined denoting a value that has changed and has a sign corresponding to a binary "1" (i.e., an error). A double-underlined value denotes a bit that has been decoded correctly. We can observe that within the first iterations, all values fluctuate, however, after 6 iterations, the decoder gets trapped in the trapping set and further iterations do not lead to any changes.

If we now switch off the offset-correction (i.e., use pure min-sum decoding) after the 6$^{th}$ iteration, we can observe in **Fig. 10** that the decoder is able to recover from the trapping set within two iterations and that all bits can be decoded correctly (positive a-posteriori values, double-underlined). This behavior can be observed for most of the trapping sets/absorbing sets that have occurred even with this simple instance of the proposed decoder.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

**1.** A decoder (500) for iteratively decoding an LDPC encoded code word, the decoder comprising:

a decoding module (502) operable to decode the LDPC encoded code word according to an offset min-sum decoding rule applying at least one offset correction value ($\beta_1$; $\beta_2$) to a min-sum check-node update operation; and a processor (506) to select, from a plurality of computation rules, a computation rule for the at least one offset correction value ($\beta_1$; $\beta_2$) dependent on a selection criterion.

**2.** The decoder (500) of claim 1, wherein the selection criterion corresponds to a number of decoding iterations, to a number of unfulfilled check node operations, reliability values of a number of variable nodes participating in unfulfilled check node operations, or a combination thereof.

**3.** The decoder (500) of claim 1, wherein the processor (506) is operable to select, from a plurality of constant values, a constant value for the at least one offset correction value ($\beta_1$; $\beta_2$), the constant value depending on the selection criterion.

**4.** The decoder (500) of claim 1, wherein the processor (506) is operable to set the at least one offset correction value ($\beta_1$; $\beta_2$) to zero if a zero selection criterion is fulfilled, such that the decoding module decodes the LDPC encoded code words according to the min-sum check-node update operation.

**5.** The decoder (500) of claim 4, wherein the zero selection criterion is fulfilled if a number of decoding iterations exceeds an iteration threshold value.

**6.** The decoder (500) of claim 4, wherein the zero selection criterion is fulfilled if a number of unfulfilled check node operations is below a check node threshold value and/or the number of unfulfilled check node operations does not substantially vary between subsequent iterations.

**7.** The decoder (500) of claim 1, wherein the processor (506) is operable to select a first computation rule for the at least one offset correction value ($\beta_1$; $\beta_2$) if a first selection criterion is fulfilled and/or to select a second computation

rule for the at least one offset correction value ($\beta_1$; $\beta_2$) if a second selection criterion is fulfilled.

**8.** The decoder (500) of claim 1, wherein the min-sum check-node update operation comprises updating an extrinsic memory value $e_{m,i}$ for row *m* and line *i* of a parity check matrix of an employed LDPC code corresponding to

$$e_{m,i} = \left[ \prod_{j \in \mathcal{N}(m) \setminus \{i\}} \text{sign}(t_{k,j}) \right] \min_{j \in \mathcal{N}(m) \setminus \{i\}} |t_{m,j}| \qquad \text{for all } i \in \mathcal{N}(m),$$

with

$$t_{m,i} = \hat{z}_i - e_{m,i} \qquad \text{for all } i \in \mathcal{N}(m)$$

wherein *N(m)* denotes the positions of ones in the *m*-th row of the parity check matrix, and $\hat{z}_i$ denotes an estimate of a received sample of the LDPC encoded code word corresponding to the *i*-th line of the parity check matrix.

**9.** The decoder (500) of claim 1, wherein a check-node update operation of the offset min-sum decoding rule comprises updating an extrinsic memory value $e_{m,i}$ for row *m* and line *i* of the parity check matrix of an employed LDPC code corresponding to

$$e_{m,i} = s_m \cdot \text{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases}$$

with

$$t_{m,i} = \hat{z}_i - e_{m,i} \qquad \text{for all } i \in \mathcal{N}(m) \ ,$$

wherein *N*(*m*) denotes the positions of ones in the *m*-th row of the parity check matrix, $\hat{\hat{z}}_i$ denotes an estimate of a received sample of the LDPC encoded code word corresponding to the *i*-th line of the parity check matrix, $\beta$ denotes the at least one offset correction value, and

wherein $$s_m = \prod_{j \in \mathcal{N}(m)} \text{sign}(t_{m,j})$$ and

$$\mu_m^{[1]} = \min_{j \in \mathcal{N}(m)} |t_{m,j}| \text{ and } i_m^{[1]} = \arg \min_{j \in \mathcal{N}(m)} |t_{m,j}|, \text{ and } \mu_m^{[2]} = \min_{j \in \mathcal{N}(m) \setminus \{i_m^{[1]}\}} |t_{m,j}|.$$

**10.** The decoder (500) of claim 1, wherein the processor (506) is operable to select the quantization resolution of the iterative LDPC decoder in accordance with the selection criterion.

**11.** The decoder (500) of claim 1, wherein the decoder comprises a plurality of decoding modules (502), wherein a total number of decoding modules (502) corresponds to a total number of decoding iterations, wherein a first number of decoding modules corresponding to a first number of decoding iterations operates in accordance with an offset min-sum decoding rule applying at least one non-zero offset correction value to a min-sum check-node update operation, and wherein a second number of decoding modules corresponding to a second number of decoding iterations operates in accordance with a pure min-sum check-node update operation.

**12.** A method for iteratively decoding an LDPC encoded code word, the method comprising:

decoding the LDPC encoded code word according to an offset min-sum decoding rule applying at least one offset correction value ($\beta_1$; $\beta_2$) to a min-sum check-node update operation; and
selecting, from a plurality of computation rules, a computation rule for the at least one offset correction value ($\beta_1$; $\beta_2$) dependent on a selection criterion.

**13.** Computer program having a program code for performing the method of claim 12, when the computer program is executed on a programmable hardware device.

**Amended claims in accordance with Rule 137(2) EPC.**

**1.** A decoder (500) for iteratively decoding an LDPC encoded code word, the decoder composing:

a decoding module (502) operable to decode the LDPC encoded code word according to an offset min-sum decoding rule applying at least one offset correction value ($\beta_1$; $\beta_2$) to a min-sum check-node update operation; and
a processor (506) to select, from a plurality of computation rules, a computation rule for the at least one offset correction value ($\beta_1$; $\beta_2$) dependent on a selection criterion,
wherein the processor (506) is operable to set the at least one offset correction value ($\beta_1$; $\beta_2$) to zero if a zero selection criterion is fulfilled, such that the decoding module decodes the LDPC encoded code words according to the min-sum check-node update operation,
wherein the zero selection criterion is fulfilled if a number of unfulfilled check node operations is below a check node threshold value and/or the number of unfulfilled check node operations does not substantially vary between subsequent iterations.

**2.** The decoder (500) of claim 1, wherein the selection criterion corresponds to a number of decoding iterations, to a number of unfulfilled check node operations, reliability values of a number of variable nodes participating in unfulfilled check node operations, or a combination thereof.

**3.** The decoder (500) of claim 1, wherein the processor (506) is operable to select, from a plurality of constant values, a constant value for the at least one offset correction value ($\beta_1$; $\beta_2$), the constant value depending on the selection criterion.

**4.** The decoder (500) of claim 1, wherein the zero selection criterion is fulfilled if a number of decoding iterations exceeds an iteration threshold value.

**5.** The decoder (500) of claim 1, wherein the processor (506) is operable to select a first computation rule for the at least one offset correction value ($\beta_1$; $\beta_2$) if a first selection criterion is fulfilled and/or to select a second computation rule for the at least one offset correction value ($\beta_1$; $\beta_2$) if a second selection criterion is fulfilled.

**6.** The decoder (500) of claim 1, wherein the min-sum check-node update operation comprises updating an extrinsic memory value $e_{m,i}$ for row $m$ and line $i$ of a parity check matrix of an employed LDPC code corresponding to

$$e_{m,i} = \left[ \prod_{j \in \mathcal{N}(m)\setminus\{i\}} \operatorname{sign}(t_{k,j}) \right] \min_{j \in \mathcal{N}(m)\setminus\{i\}} |t_{m,j}| \qquad \text{for all } i \in \mathcal{N}(m),$$

with

$$t_{m,i} = \hat{z}_i - e_{m,i} \qquad \text{for all } i \in \mathcal{N}(m)$$

wherein $N(m)$ denotes the positions of ones in the $m$-th row of the parity check matrix, and
$\hat{z}_i$ denotes an estimate of a received sample of the LDPC encoded code word corresponding to the $i$-th line of the parity check matrix.

7. The decoder (500) of claim 1, wherein a check-node update operation of the offset min-sum decoding rule comprises updating an extrinsic memory value $e_{m,i}$ for row $m$ and line $i$ of the parity check matrix of an employed LDPC code corresponding to

$$e_{m,i} = s_m \cdot \mathrm{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases}$$

with

$$t_{m,i} = \hat{z}_i - e_{m,i} \qquad \text{for all } i \in \mathcal{N}(m) \ ,$$

wherein $N(m)$ denotes the positions of ones in the $m$-th row of the parity check matrix, $\hat{z}_i$ denotes an estimate of a received sample of the LDPC encoded code word corresponding to the $i$-th line of the parity check matrix, $\beta$ denotes the at least one offset correction value, and

wherein $s_m = \prod_{j \in \mathcal{N}(m)} \mathrm{sign}(t_{m,j})$ and

$$\mu_m^{[1]} = \min_{j \in \mathcal{N}(m)} |t_{m,j}| \text{ and } i_m^{[1]} = \arg \min_{j \in \mathcal{N}(m)} |t_{m,j}| \text{, and } \mu_m^{[2]} = \min_{j \in \mathcal{N}(m) \setminus \{i_m^{[1]}\}} |t_{m,j}| \ .$$

8. The decoder (500) of claim 1, wherein the processor (506) is operable to select the quantization resolution of the iterative LDPC decoder in accordance with the selection criterion.

9. The decoder (500) of claim 1, wherein the decoder comprises a plurality of decoding modules (502), wherein a total number of decoding modules (502) corresponds to a total number of decoding iterations, wherein a first number of decoding modules corresponding to a first number of decoding iterations operates in accordance with an offset min-sum decoding rule applying at least one non-zero offset correction value to a min-sum check-node update operation, and wherein a second number of decoding modules corresponding to a second number of decoding iterations operates in accordance with a pure min-sum check-node update operation.

10. A method for iteratively decoding an LDPC encoded code word, the method compissing:

decoding the LDPC encoded code word according to an offset min-sum decoding rule applying at least one offset correction value ($\beta_1$; $\beta_2$) to a min-sum check-node update operation; and
selecting, from a plurality of computation rules, a computation rule for the at least one offset correction value ($\beta_1$; $\beta_2$) dependent on a selection criterion,
wherein the at least one offset correction value ($\beta_1$; $\beta_2$) is set to zero if a zero selection criterion is fulfilled, such that the LDPC encoded code words are decoded according to the min-sum check-node update operation, and wherein the zero selection criterion is fulfilled if a number of unfulfilled check node operations is below a check node threshold value and/or the number of unfulfilled check node operations does not substantially vary between subsequent iterations.

11. Computer program having a program code for performing the method of claim 10, when the computer program is executed on a programmable hardware device.

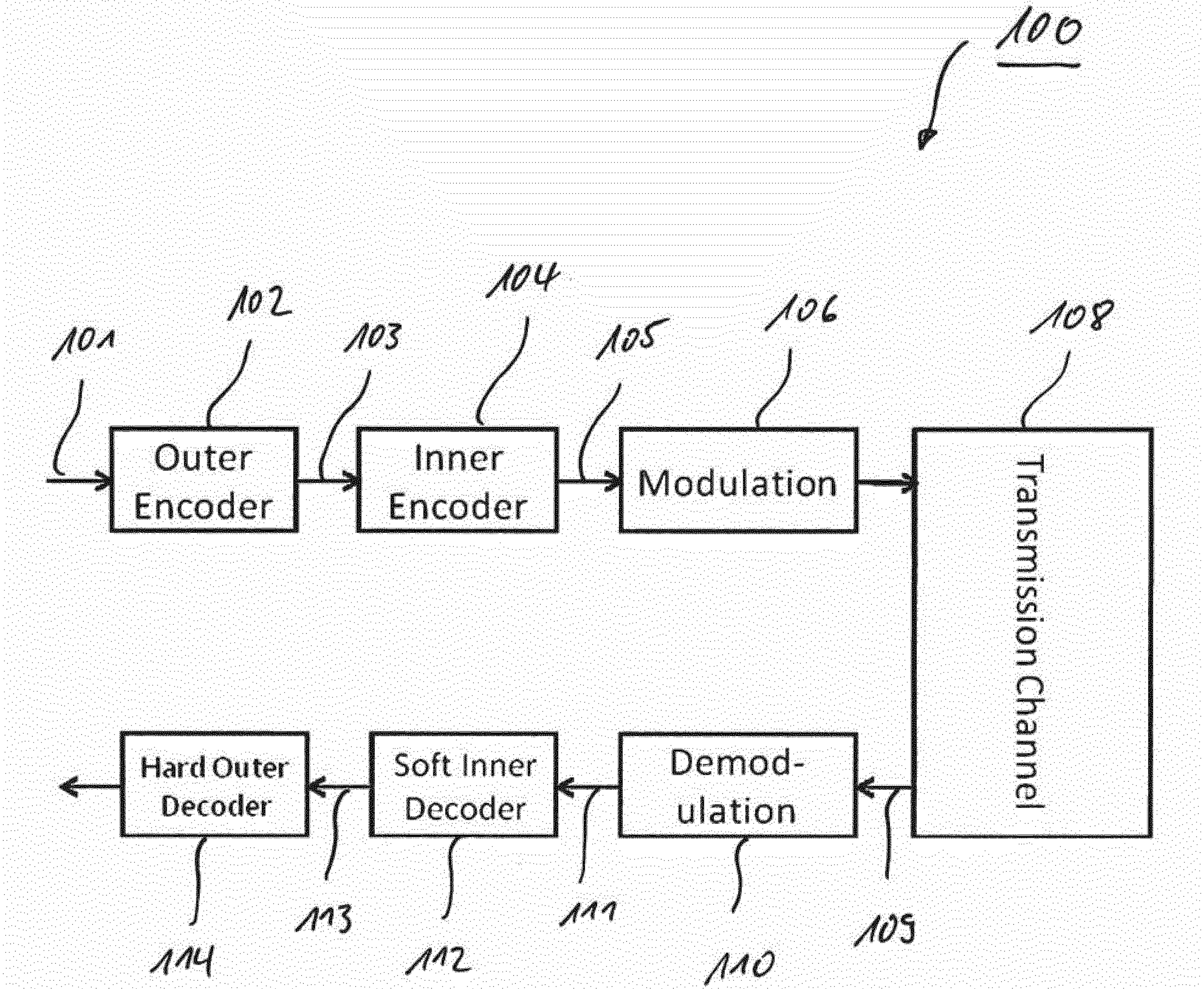
100
101
102
103
104
105
106
108
Outer Encoder
Inner Encoder
Modulation
Transmission Channel
Hard Outer Decoder
Soft Inner Decoder
Demod-ulation
114
113
112
111
110
109

Fig. 1

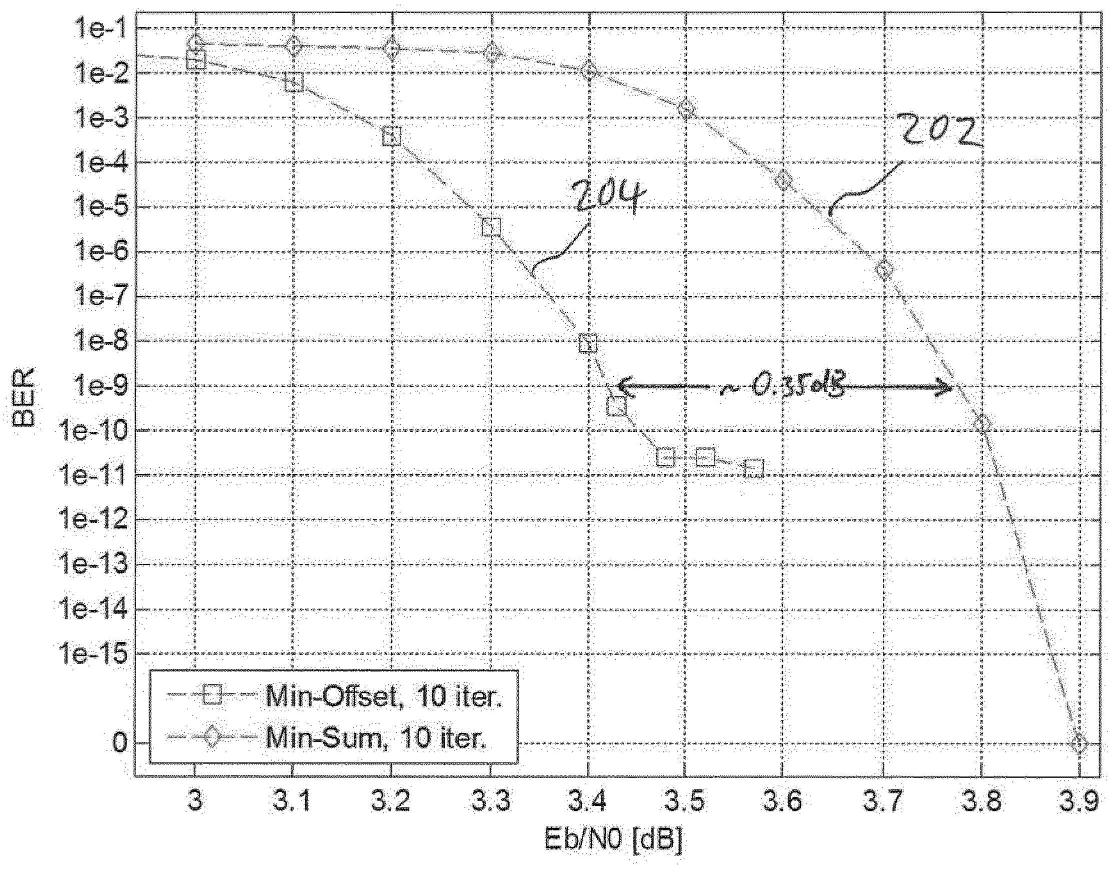
1e-1
1e-2
1e-3
1e-4
1e-5
1e-6
1e-7
1e-8
1e-9
1e-10
1e-11
1e-12
1e-13
1e-14
1e-15
0
BER
3
3.1
3.2
3.3
3.4
3.5
3.6
3.7
3.8
3.9
Eb/N0 [dB]
202
204
~ 0.35dB
Min-Offset, 10 iter.
Min-Sum, 10 iter.

Fig. 2

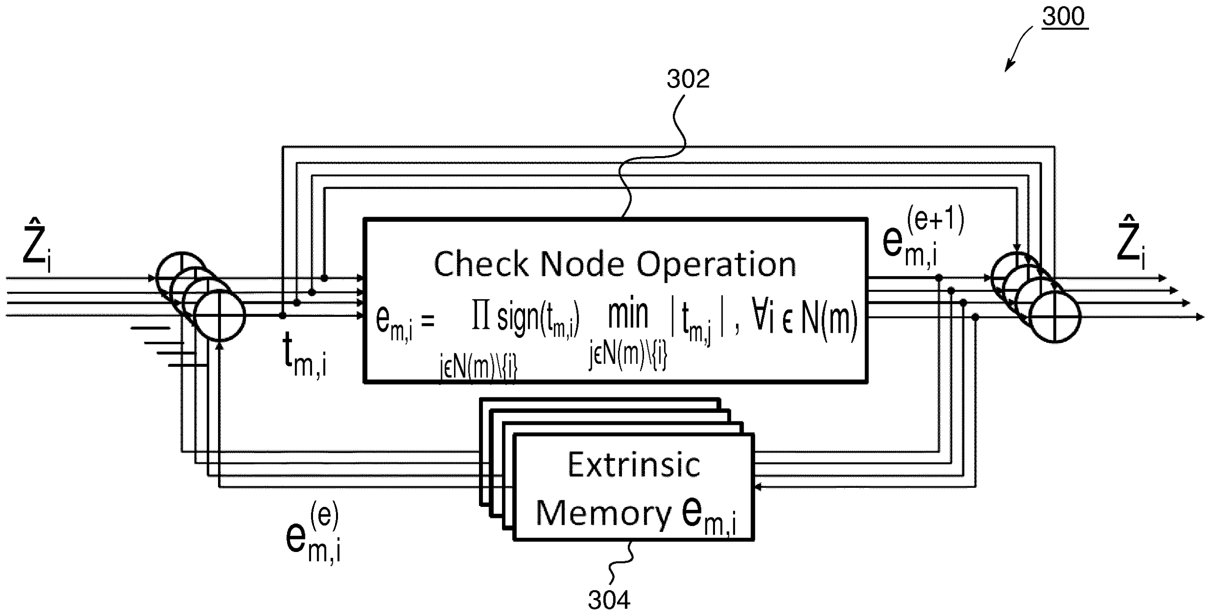
300
302
$\hat{Z}_i$
Check Node Operation
$e_{m,i} = \prod_{j\in N(m)\setminus\{i\}} sign(t_{m,i}) \min_{j\in N(m)\setminus\{i\}} |t_{m,j}|, \forall i \in N(m)$
$e_{m,i}^{(e+1)}$
$\hat{Z}_i$
$t_{m,i}$
Extrinsic
Memory $e_{m,i}$
$e_{m,i}^{(e)}$
304

Fig. 3

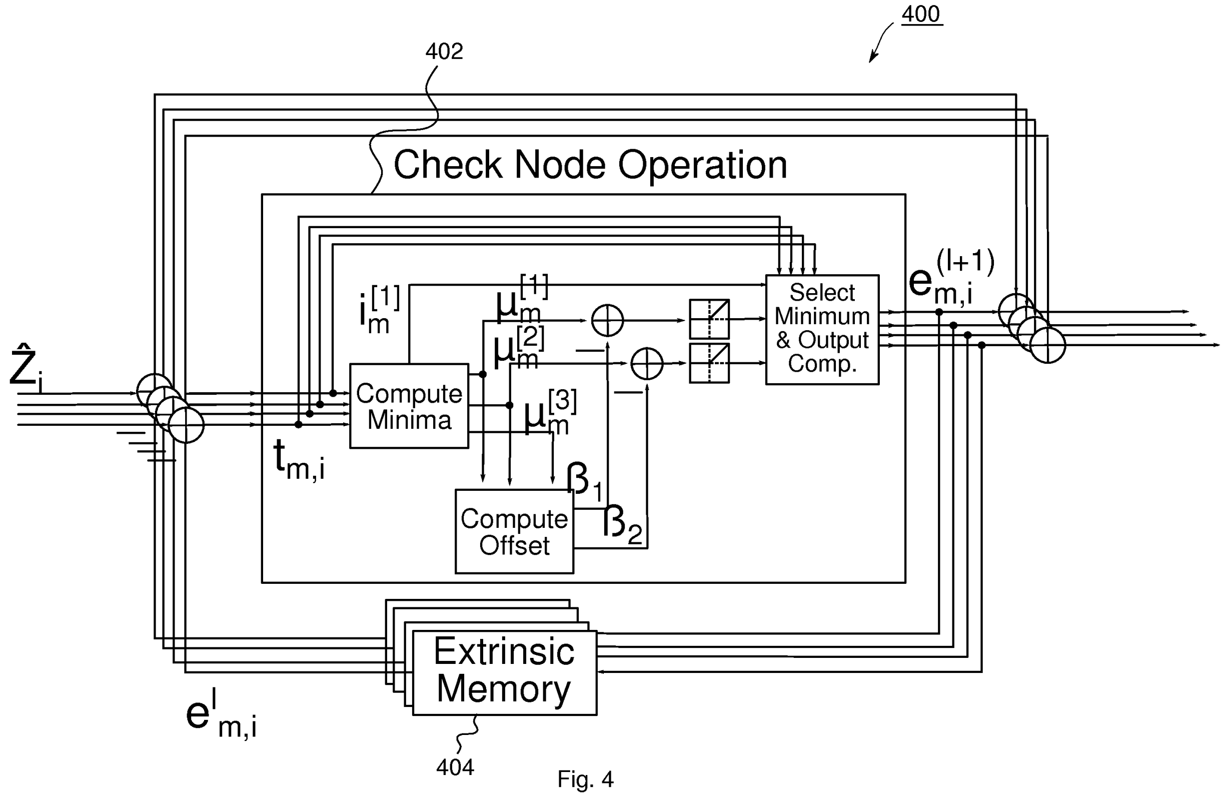
400
402
Check Node Operation
$\hat{z}_i$
$t_{m,i}$
$i_m^{[1]}$
$\mu_m^{[1]}$
$\mu_m^{[2]}$
$\mu_m^{[3]}$
Compute Minima
Compute Offset
$\beta_1$
$\beta_2$
Select Minimum & Output Comp.
$e_{m,i}^{(l+1)}$
Extrinsic Memory
$e^l_{m,i}$
404

Fig. 4

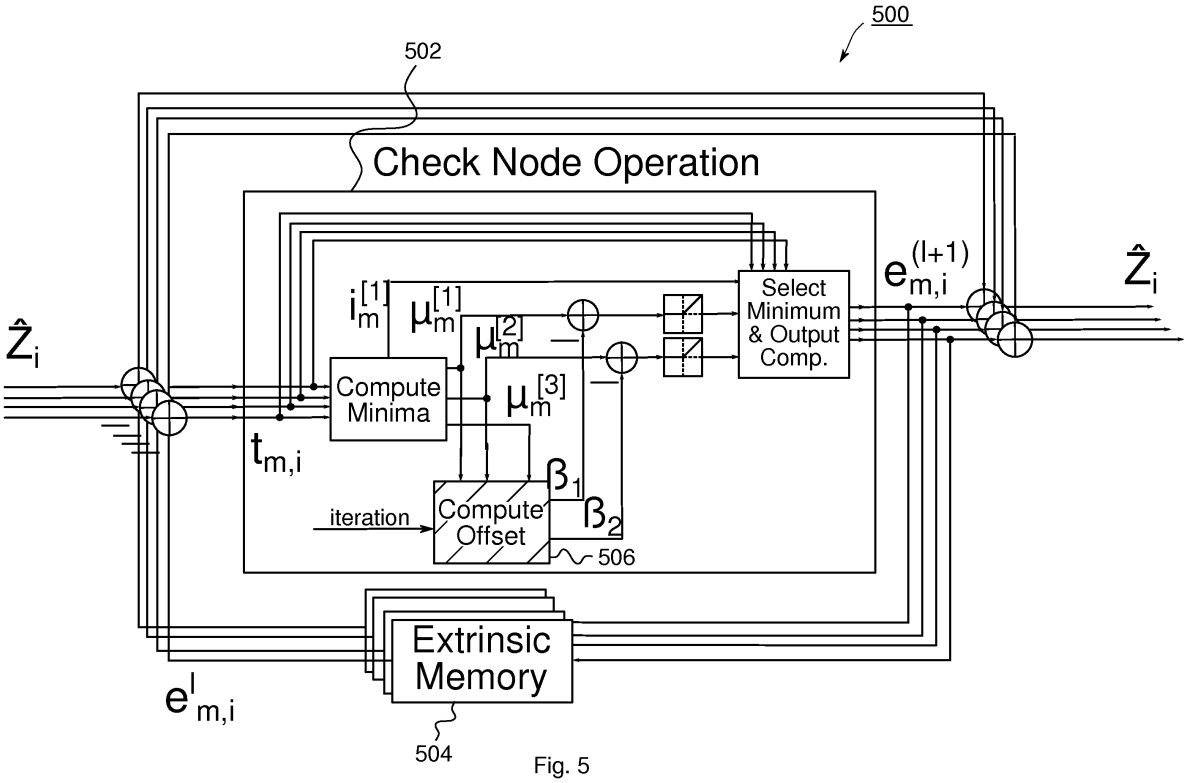
500
502
Check Node Operation
Ẑi
Ẑi
$e_{m,i}^{(l+1)}$
$i_m^{[1]}$
$\mu_m^{[1]}$
$\mu_m^{[2]}$
$\mu_m^{[3]}$
Select Minimum & Output Comp.
Compute Minima
$t_{m,i}$
$\beta_1$
$\beta_2$
iteration
Compute Offset
506
Extrinsic Memory
$e^l_{m,i}$
504

Fig. 5

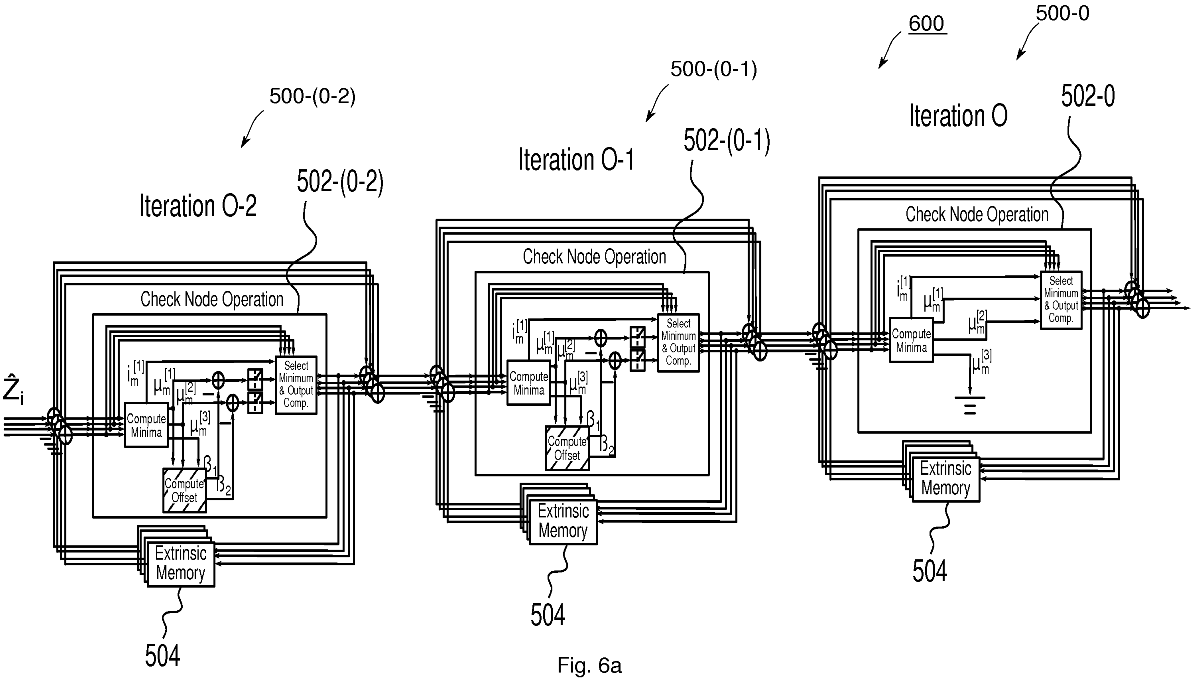
600
500-(0-2)
500-(0-1)
500-0
Iteration O-2
Iteration O-1
Iteration O
502-(0-2)
502-(0-1)
502-0
Check Node Operation
Check Node Operation
Check Node Operation
Compute Minima
Compute Minima
Compute Minima
Compute Offset
Compute Offset
Select Minimum & Output Comp.
Select Minimum & Output Comp.
Select Minimum & Output Comp.
Extrinsic Memory
Extrinsic Memory
Extrinsic Memory
504
504
504

Fig. 6a

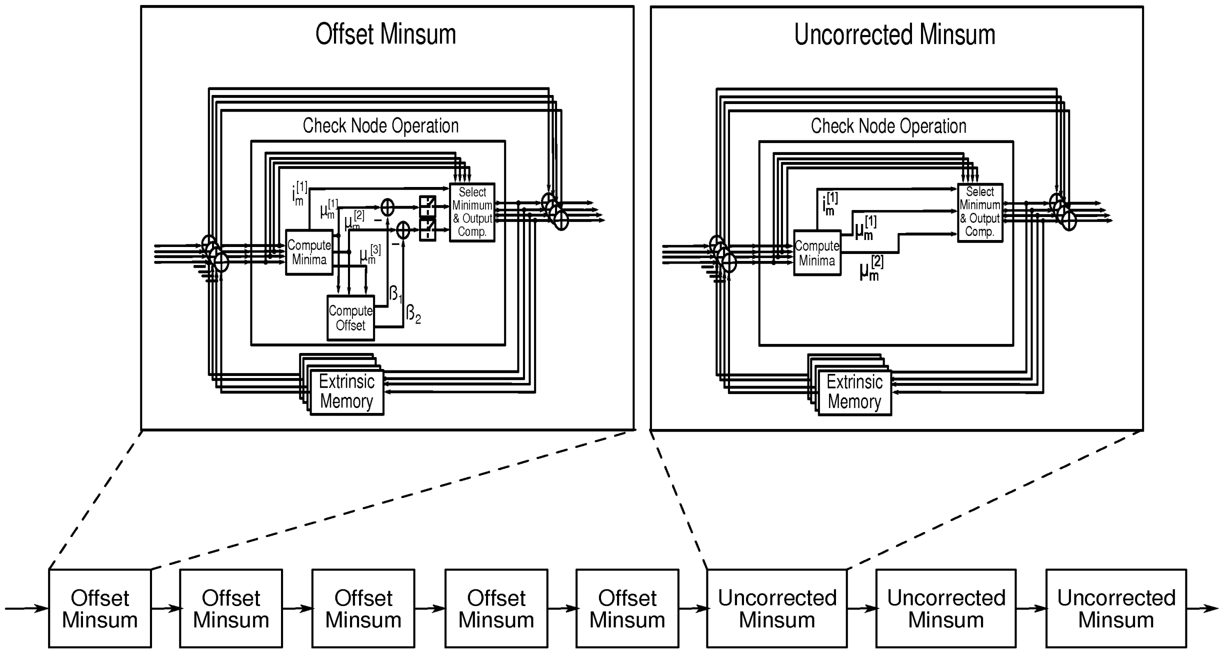
Offset Minsum
Check Node Operation
Compute Minima
Compute Offset
Select Minimum & Output Comp.
Extrinsic Memory
Uncorrected Minsum
Check Node Operation
Compute Minima
Select Minimum & Output Comp.
Extrinsic Memory
Offset Minsum
Offset Minsum
Offset Minsum
Offset Minsum
Offset Minsum
Uncorrected Minsum
Uncorrected Minsum
Uncorrected Minsum

Fig. 6b

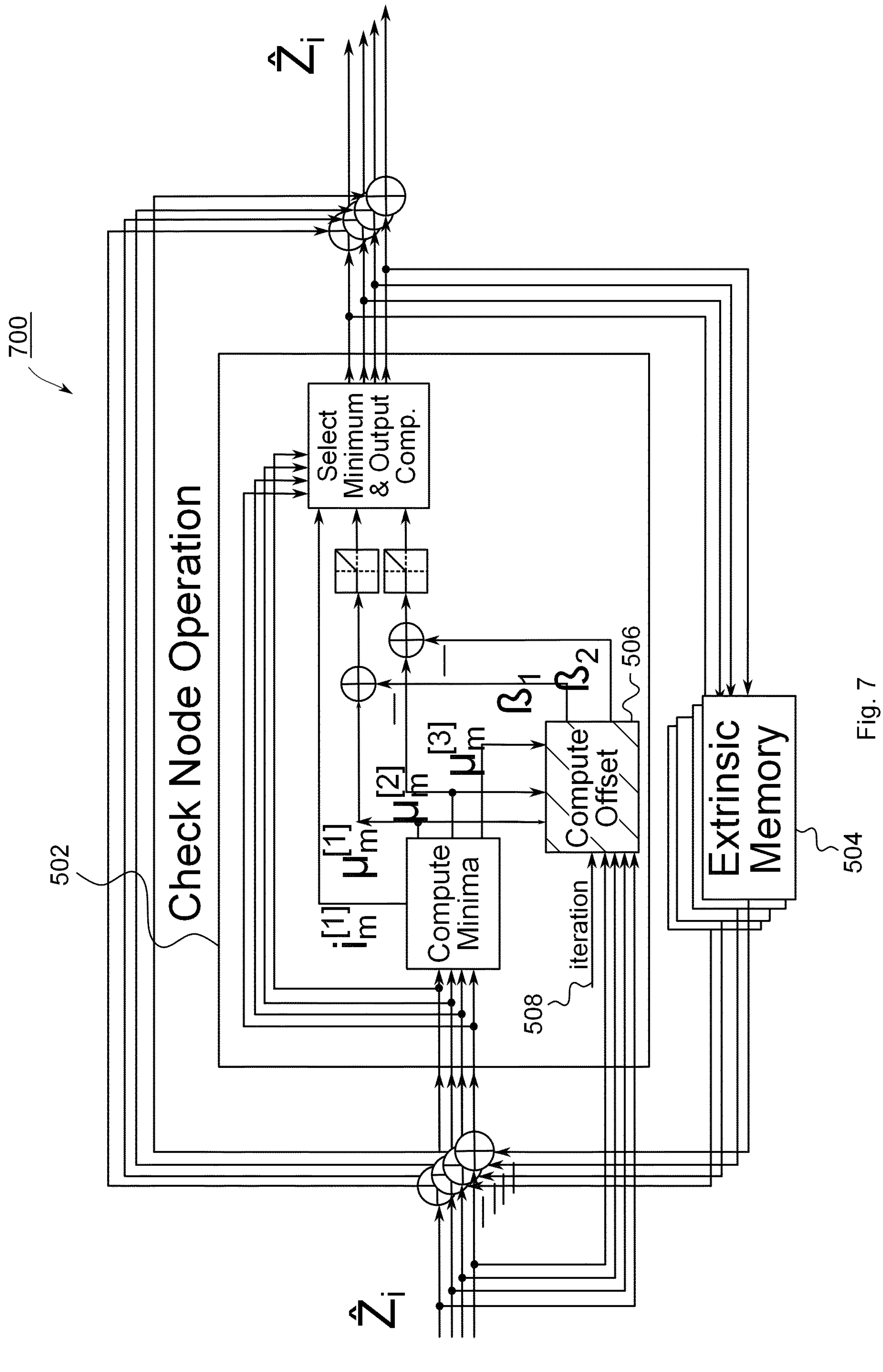
700
502
Check Node Operation
Compute Minima
$i_m^{[1]}$
$\mu_m^{[1]}$
$\mu_m^{[2]}$
$\mu_m^{[3]}$
Compute Offset
506
$\beta_1$
$\beta_2$
Select Minimum & Output Comp.
iteration
508
Extrinsic Memory
504
$\hat{Z}_i$
$\hat{Z}_i$

Fig. 7

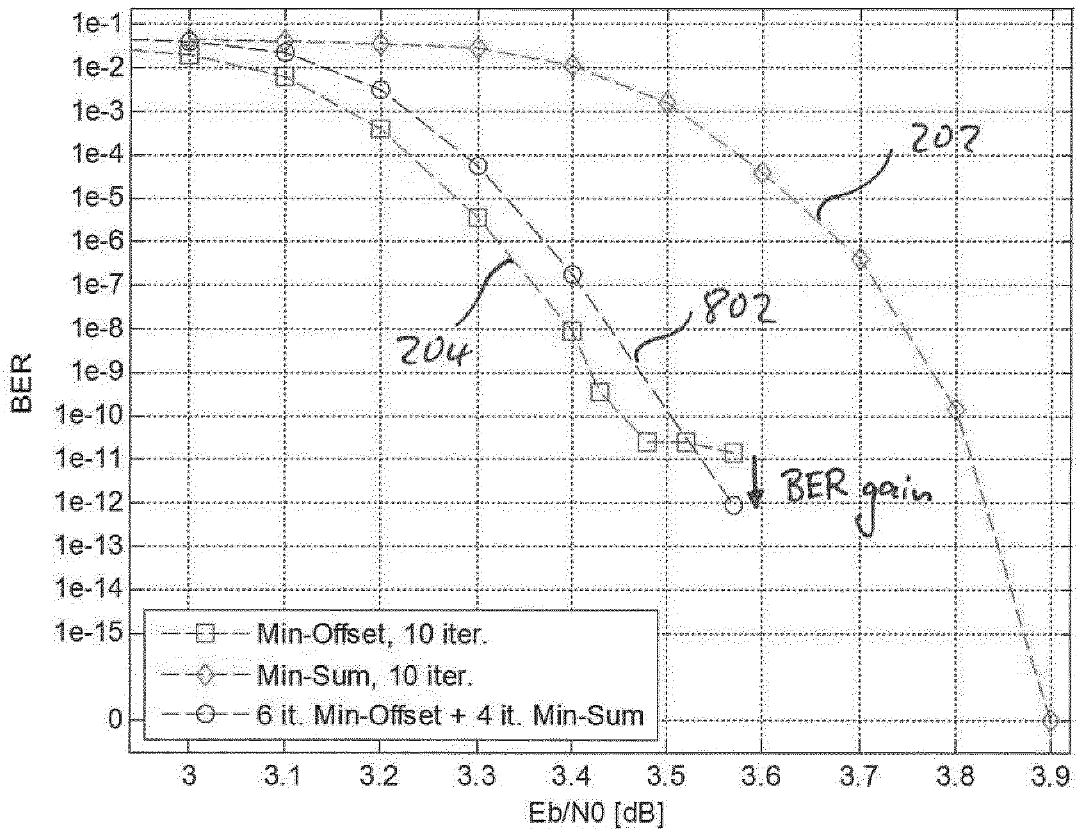
BER
1e-1
1e-2
1e-3
1e-4
1e-5
1e-6
1e-7
1e-8
1e-9
1e-10
1e-11
1e-12
1e-13
1e-14
1e-15
0
3
3.1
3.2
3.3
3.4
3.5
3.6
3.7
3.8
3.9
Eb/N0 [dB]
Min-Offset, 10 iter.
Min-Sum, 10 iter.
6 it. Min-Offset + 4 it. Min-Sum
202
204
802
BER gain

Fig. 8

ALU130704PAEP

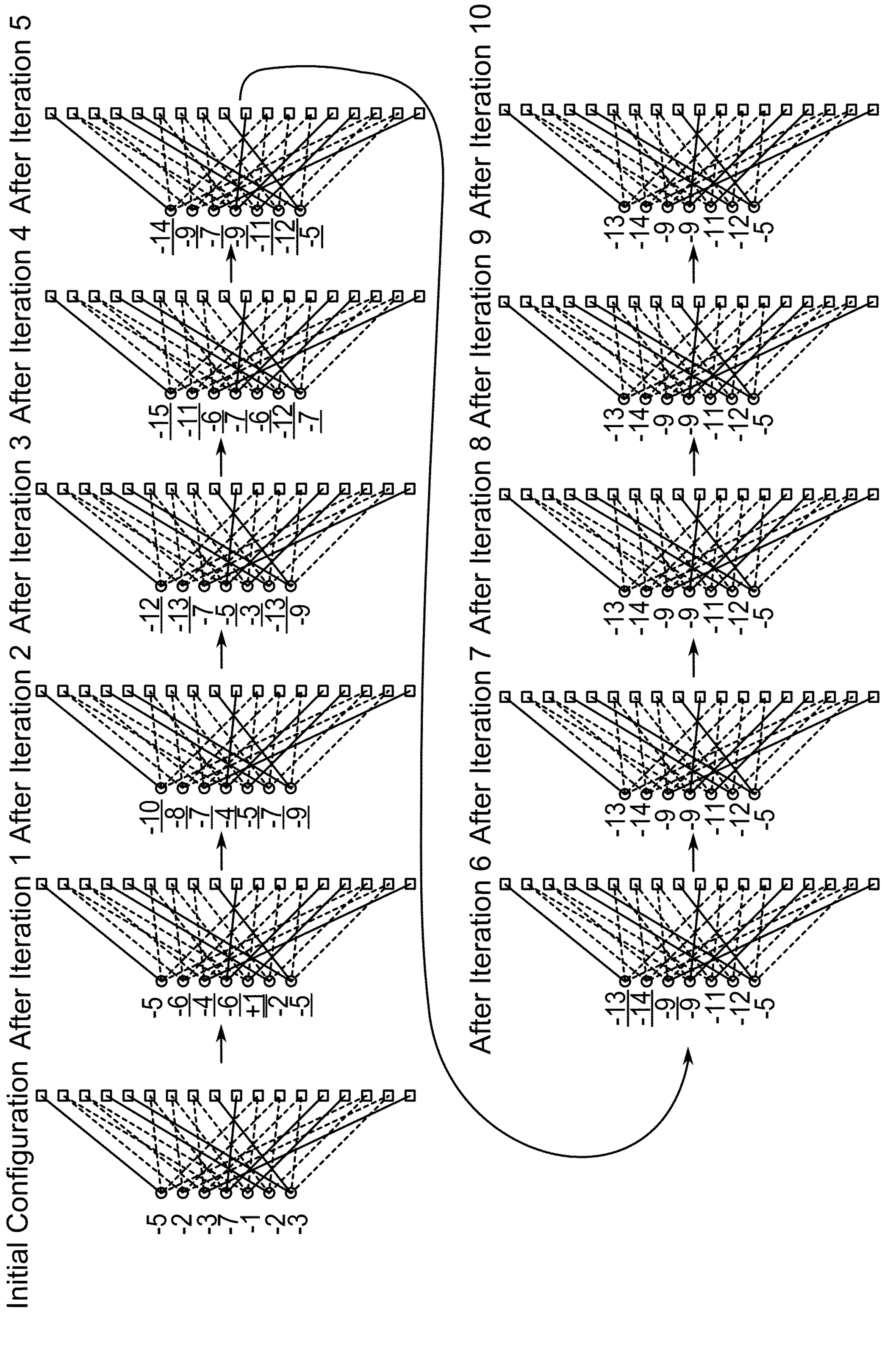


Fig. 9

ALU130704PAEP

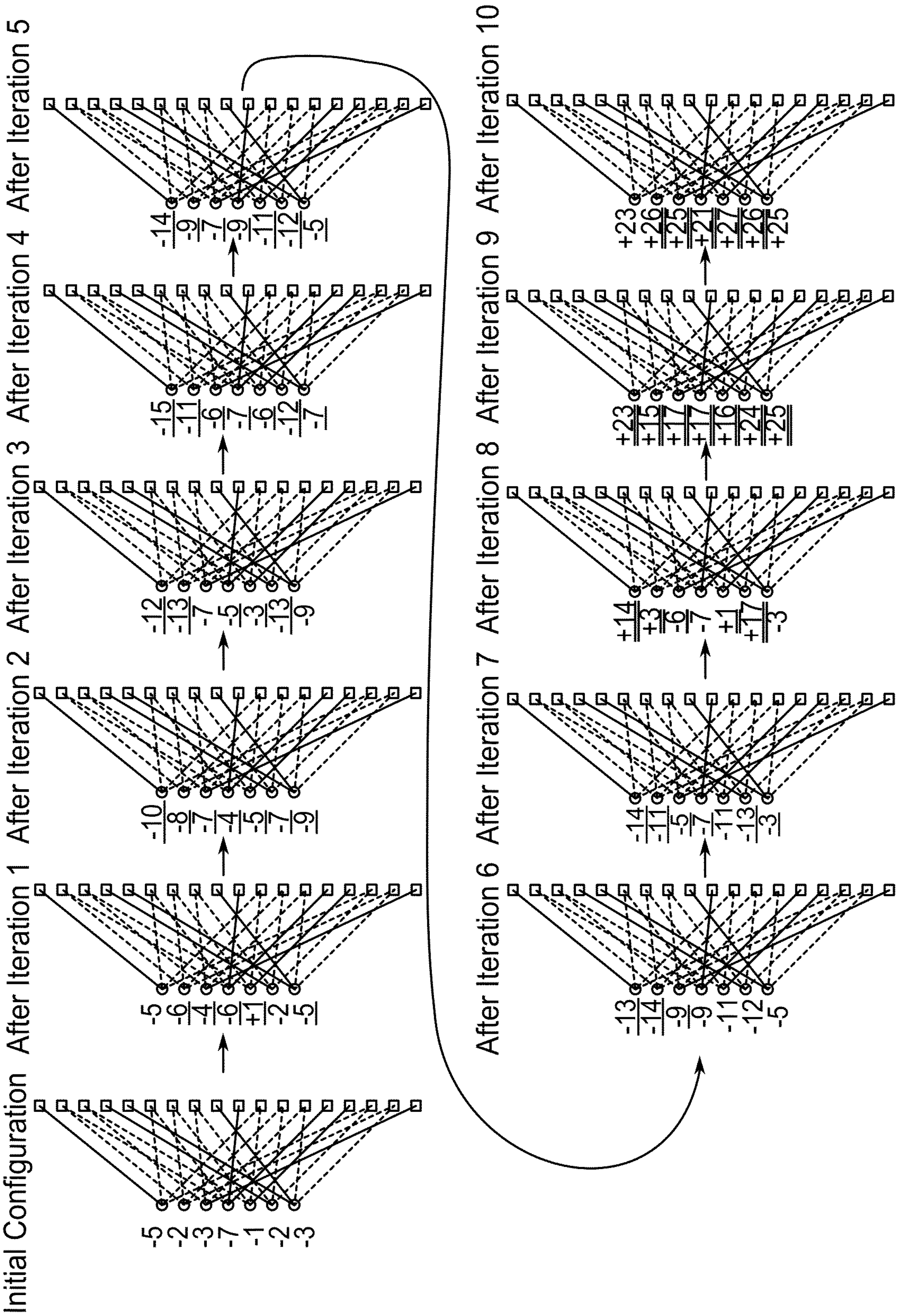


Fig. 10

Europäisches Patentamt
European Patent Office
Office européen des brevets

# EUROPEAN SEARCH REPORT

Application Number
EP 14 30 5002

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JINGHU CHEN ET AL: "Improved min-sum decoding algorithms for irregular LDPC codes", PROC., IEEE INTERNATIONAL SYMPOSIUM ON INFORMATION THEORY, ISIT 2005, ADELAIDE, AUSTRALIA, 4 September 2005 (2005-09-04), - 9 September 2005 (2005-09-09), pages 449-453, XP010846293, DOI: 10.1109/ISIT.2005.1523374 ISBN: 978-0-7803-9151-2 | 1-5,7-9, 12,13 | INV. H03M13/11 H03M13/37 ADD. H03M13/15 H03M13/29 |
| Y | * the whole document * | 10,11 | |
| A | | 6 | |
| | ----- | | |
| X | EP 2 264 906 A2 (MITSUBISHI ELECTRIC CORP [JP]) 22 December 2010 (2010-12-22) | 1-4,7-9, 12,13 | |
| Y | * the whole document * | 10 | |
| A | | 6,11 | |
| | ----- | | |
| X | HOWARD SH. ET AL: "Degree-Matched Check Node Decoding for Regular and Irregular LDPCs", IEEE TRANSACTIONS ON CIRCUITS AND SYSTEMS II: ANALOG AND DIGITALSIGNAL PROCESSING, INSTITUTE OF ELECTRICAL AND ELECTRONICS ENGINEERS INC, 345 EAST 47 STREET, NEW YORK, N.Y. 10017, USA, vol. 53, no. 10, 1 October 2006 (2006-10-01), pages 1054-1058, XP011142490, ISSN: 1057-7130, DOI: 10.1109/TCSII.2006.882204 | 1-4,7-9, 12,13 | TECHNICAL FIELDS SEARCHED (IPC) |
| | | | H03M |
| Y | * the whole document * | 10 | |
| A | | 6,11 | |
| | ----- | | |
| | -/-- | | |

The present search report has been drawn up for all claims

2

| Place of search | Date of completion of the search | Examiner |
|---|---|---|
| Munich | 10 March 2014 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 14 30 5002

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | US 2010/262888 A1 (CHOI EUNA [KR] ET AL) 14 October 2010 (2010-10-14)<br>* paragraph [0065] - paragraph [0095]; figures 3,4 * | 1-5,8,9, 12,13<br>10 | |
| X<br><br>Y<br>A | XIAOFU WU ET AL: "Adaptive-Normalized/Offset Min-Sum Algorithm", IEEE COMMUNICATIONS LETTERS, IEEE, USA, vol. 14, no. 7, 1 July 2010 (2010-07-01), pages 667-669, XP011316423,<br>* the whole document * | 1-3,7-9, 12,13<br><br>10<br>6,11 | |
| X<br><br>A | CHA-HAO CHUNG ET AL: "Adaptive quantization for low-density-parity-check decoders", PROC., IEEE INTERNATIONAL SYMPOSIUM ON INFORMATION THEORY AND ITS APPLICATIONS (ISITA), 2010, 17 October 2010 (2010-10-17), pages 13-18, XP031811518, ISBN: 978-1-4244-6016-8<br>* the whole document * | 1-4, 8-10,12, 13<br><br>5-7,11 | TECHNICAL FIELDS SEARCHED (IPC) |
| X<br><br>Y<br>A | MING JIANG ET AL: "Adaptive Offset Min-Sum Algorithm for Low-Density parity Check Codes", IEEE COMMUNICATIONS LETTERS, IEEE SERVICE CENTER, PISCATAWAY, NJ, US, vol. 10, no. 6, 1 June 2006 (2006-06-01), pages 483-485, XP001546981, ISSN: 1089-7798, DOI: 10.1109/LCOMM.2006.1638623<br>* the whole document * | 1,7-9, 12,13<br><br>10<br>6,11 | |

-/--

The present search report has been drawn up for all claims

2

| Place of search | Date of completion of the search | Examiner |
|---|---|---|
| Munich | 10 March 2014 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 14 30 5002

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YEONG-LUH UENG ET AL: "An Efficient Multi-Standard LDPC Decoder Design Using Hardware-Friendly Shuffled Decoding", IEEE TRANSACTIONS ON CIRCUITS AND SYSTEMS I: REGULAR PAPERS, IEEE, US, vol. 60, no. 3, 1 March 2013 (2013-03-01), pages 743-756, XP011495091, ISSN: 1549-8328, DOI: 10.1109/TCSI.2012.2215746 | 1,3,7-9, 12,13 | |
| Y | * page 744 - page 745 * | 10 | |
| A | | 6,11 | |
| X | WO 2006/123543 A1 (MITSUBISHI ELECTRIC CORP [JP]; ZHANG JUNTAN [US]; GU DAQING [US]; ZHAN) 23 November 2006 (2006-11-23) | 1-3,7-9, 12,13 | |
| Y | * page 11 - page 12 * * abstract * | 10 | |
| Y | US 8 429 482 B1 (PAYNE ROBERT E [GB] ET AL) 23 April 2013 (2013-04-23) * the whole document * | 11 | |

TECHNICAL FIELDS SEARCHED (IPC)

The present search report has been drawn up for all claims

| Place of search | Date of completion of the search | Examiner |
|---|---|---|
| Munich | 10 March 2014 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

2

EPO FORM 1503 03.82 (P04C01)

## ANNEX TO THE EUROPEAN SEARCH REPORT ON EUROPEAN PATENT APPLICATION NO. EP 14 30 5002

This annex lists the patent family members relating to the patent documents cited in the above-mentioned European search report. The members are as contained in the European Patent Office EDP file on
The European Patent Office is in no way liable for these particulars which are merely given for the purpose of information.

10-03-2014

| Patent document cited in search report | Publication date | Patent family member(s) | Publication date |
|---|---|---|---|
| EP 2264906 A2 | 22-12-2010 | CN 101931418 A | 29-12-2010 |
| | | EP 2264906 A2 | 22-12-2010 |
| | | JP 2011004229 A | 06-01-2011 |
| | | US 2010325514 A1 | 23-12-2010 |
| US 2010262888 A1 | 14-10-2010 | KR 20090064268 A | 18-06-2009 |
| | | US 2010262888 A1 | 14-10-2010 |
| WO 2006123543 A1 | 23-11-2006 | CN 101107782 A | 16-01-2008 |
| | | EP 1884023 A1 | 06-02-2008 |
| | | JP 5138221 B2 | 06-02-2013 |
| | | JP 2008541496 A | 20-11-2008 |
| | | US 2006282742 A1 | 14-12-2006 |
| | | WO 2006123543 A1 | 23-11-2006 |
| US 8429482 B1 | 23-04-2013 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **D. E. HOCEVAR.** A Reduced Complexity Decoder Architecture via Layered Decoding of LDPC Codes. *Proc. IEEE Workshop on Signal Processing Systems (SIPS,* 2004
- **J. ZHAO ; F. ZARKESHVARI ; A. H. BANIHASHEMI.** On Implementation of Min-Sum Algorithm and Its Modifications for Decoding Low-Density Parity-Check (LDPC) Codes. *IEEE Trans. Commun.,* April 2005, vol. 53 (4
- **W. E. RYAN ; S. LIN.** Channel Codes - Classical and Modem. Cambridge University Press, 2009